# EUROPEAN PATENT APPLICATION

(11) **EP 3 059 770 A1**
(43) Date of publication of application: **24.08.2016**
(21) Application number: 14737132.2
(22) Date of filing: 22.04.2014
(51) Int. Cl.: H01L 35/04

(54) **THERMOELECTRIC DEVICE USING SUBSTRATE AND METHOD FOR MANUFACTURING SAME**

(30) Priority: 18.10.2013 KR 20130124751
(71) Applicant: Korea Advanced Institute of Science and Technology, Daejeon 305-701 (KR)
(72) Inventor: CHO, Byung Jin, Daejeon 305-370 (KR); KIM, Sun Jin, Daejeon 305-701 (KR); WE, Ju Hyung, Daejeon 305-701 (KR)
(74) Representative: Mammel und Maser
(86) International application number: PCT/KR2014/003489
(87) International publication number: WO 2015/056855

(57) **Abstract**

The present invention relates to a thermoelectric device and a manufacturing method thereof, and a thermoelectric material is formed on a mesh type substrate made of a glass fabric, and the like. According to the present invention, since the thermoelectric material is supported by a substrate without a substrate made of alumina, and the like, the thermoelectric device has a light weight and thermal loss is minimized by the substrate to maximize thermoelectric efficiency.

## Description

### [Technical Field]

The present invention relates to a thermoelectric device and a manufacturing method thereof, and more particularly, to a thermoelectric device using a substrate made of a glass fabric, and the like and a manufacturing method thereof.

### [Background Art]

A thermoelectric effect generically names an effect in which thermal energy and electric energy interact with each other, that is, a Seebeck effect discovered by Thomas Seebeck and a Peltier effect discovered by Peltier, and a device using a thermoelectric effect is generally called a thermoelectric device.

The thermoelectric device includes a thermoelectric power generating device using the Seebeck effect in which electromotive force is generated by a temperature difference and a cooling device using the Peltier effect which is an effect in which heat is absorbed (alternatively, generated) when current is applied contrary thereto, and the like.

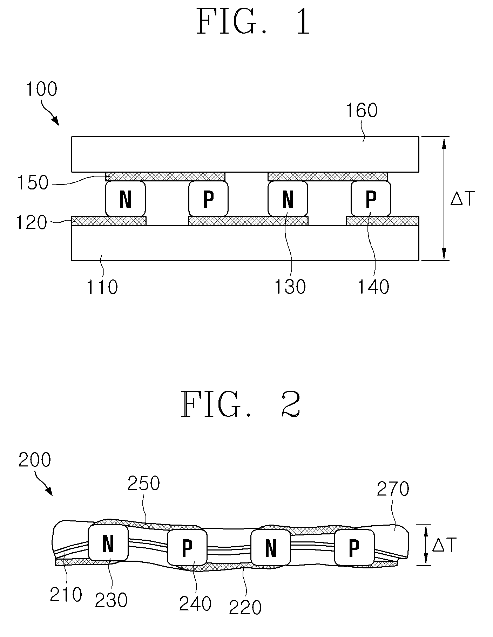

The known thermoelectric device is generally manufactured in a structure in which thermoelectric materials made of N type and P type semiconductors are formed on a substrate such as alumina (Al₂O₃), or the like, and an N type thermoelectric material and a P type thermoelectric material are connected to an electrode in series and the structure is illustrated in FIG. 1.

Referring to FIG. 1, the known thermoelectric device 100 is constituted by a lower substrate 110, a first electrode 120 formed on the lower substrate 110, an N type thermoelectric material 130 and a P type thermoelectric material 140 formed on the first electrode 120, a second electrode 150 formed to connect the N type thermoelectric material 130 and the P type thermoelectric material 140 in series together with the first electrode 120, and an upper substrate 160 positioned on the top of the second electrode 150. The manufacturing method thereof generally includes forming the first electrode 120 having a predetermined pattern on the lower substrate 110, sequentially forming the N type thermoelectric material 130 and the P type thermoelectric material 140 on the first electrode 120, and bonding the upper substrate 160 in which the second electrode 150 is formed in a predetermined pattern, and in this case, the N type thermoelectric material 130 and the P type thermoelectric material 140 are configured to be connected in series by the first electrode 120 and the second electrode 150.

However, in the known thermoelectric device 100, since the substrate such as the alumina (Al₂O₃), or the like is generally used as the lower substrate 110 and the upper substrate 160, a weight thereof is large and is not suitable for fields requiring a lightweight thermoelectric device, such as a human body, a vehicle, an airplane, and a space shuttle and thermal loss is large by the upper and lower substrates, and as a result, thermoelectric efficiency deteriorates. Further, in recent years, with technological development of a wearable computer, and the like, an interest in a thermoelectric device having a flexible characteristic has been increased, but since the known thermoelectric device 100 has no flexible characteristic, an application range of the device is narrow.

In recent years, technology that forms the thermoelectric device on a flexible substrate such as a polyethylene terephthalate (PET) film, or the like is disclosed in Korean Patent Application Publication No. 2012-0009161, but the technology also has a problem that since a substrate is still used, there is a limit in weight reduction and thermal loss by the substrate is large, thereby degrading efficiency of the thermoelectric device.

### [Disclosure]

### [Technical Problem]

The present invention is contrived to solve the problem in the related art and an object of the present invention is to provide a thermoelectric device having a lighter weight and a more flexible characteristic than a known thermoelectric device and a manufacturing method thereof.

Further, another object of the present invention is to provide a thermoelectric device which is low in thermal loss by a substrate and has excellent thermoelectric efficiency and a manufacturing method thereof.

### [Technical Solution]

An exemplary embodiment of the present invention provides a thermoelectric device, including: a mesh type substrate; an N type thermoelectric material and a P type thermoelectric material formed on the mesh type substrate; and a first electrode and a second electrode which electrically connect the N type thermoelectric material and the P type thermoelectric material in series, and may further include a filler which is filled in the thermoelectric device to support the thermoelectric device.

In this case, the mesh type substrate may penetrate and support middle parts of the N type thermoelectric material and the P type thermoelectric material and the N type thermoelectric material and the P type thermoelectric material may be alternately positioned.

The first electrode connects the N type thermoelectric material and the P type thermoelectric material on one surface of the thermoelectric device, and the second electrode connects an N type thermoelectric material and a P type thermoelectric material which are not connected by the first electrode on the other surface of the thermoelectric device to connect all N type thermoelectric materials and P type thermoelectric materials formed on the mesh type substrate in series the first electrode and the second electrode.

The mesh type substrate may be a glass fabric substrate and the mesh type substrate may have thermal conductivity of 10 W/ m·K or lower.

The N type thermoelectric material may be a bismuth-tellurium (BiₓTe₁₋ₓ) compound, and the P type thermoelectric material may be an antimony-tellurium (SbₓTe₁₋ₓ) compound, and the thermoelectric device may further include a conductive adhesive between the N type thermoelectric material and the P type thermoelectric material and the first electrode and the second electrode.

Another exemplary embodiment of the present invention provides a manufacturing method of a thermoelectric device using a mesh type substrate, including: (a) providing the mesh type substrate; (b) forming an N type thermoelectric material and a P type thermoelectric material on the mesh type substrate; and (c) forming a first electrode and a second electrode which electrically connect the N type thermoelectric material and the P type thermoelectric material in series, and filling a space between the N type thermoelectric material and the P type thermoelectric material with a filler.

Herein, step (b) may be performed by a screen printing method, and may include (b-1) thermoelectric paste synthesizing; (b-2) thermoelectric paste printing; and (b-3) drying and heat-treatment. In this case, in step (b-1), thermoelectric material powder, a solvent for controlling liquidity of paste, a binder for controlling printing resolution, and glass powder for improving adhesion may be mixed and at least a part of the thermoelectric paste passes through the mesh type substrate and may be printed in such a manner that the mesh type substrate supports a middle part of the printed thermoelectric paste by step (b-2). Further, step (b-3) may include first heat-treatment for evaporating the solvent; second heat-treatment for evaporating the binder; and third heat-treatment for increasing a thermoelectric characteristic of the thermoelectric material, and the first, second, third heat-treatments may be sequentially performed at a higher temperature.

Step (c) may include (c-1) manufacturing first and second sacrificial substrates with first and second electrode patterns; (c-2) first and second electrode bonding in which the first and second electrode patterns are bonded to the N type thermoelectric material and the P type thermoelectric material formed on the mesh type substrate to connect the N type thermoelectric material and the P type thermoelectric material in series; (c-3) filler filling of filling a space between the first sacrificial substrate and the second sacrificial substrate with a filler; and (c-4) removing the first and second sacrificial substrates. Herein, step (c-1) may include depositing a nickel (Ni) thin film on a full surface of a silicon oxide film substrate and thereafter, depositing the first and second electrode patterns thereon, step (c-2) may include applying a conductive adhesive to at least one of the thermoelectric materials and the first and second electrodes, and step (c-4) may include removing the nickel thin film which remains on both surfaces of the device after peeling an interface between the silicon substrate and the nickel thin film of the first and second sacrificial substrates.

### [Advantageous Effects]

According to a thermoelectric device and a manufacturing method thereof in accordance with the present invention, a mesh shaped substrate is used without upper and lower substrates to achieve flexibility and remarkably reduce a weight.

Further, according to the thermoelectric device and the manufacturing method thereof in accordance with the present invention, since thermal loss is minimized by a substrate, thermoelectric efficiency can be maximized.

### [Description of Drawings]

FIG. 1 is a cross-sectional view of a known thermoelectric device.
FIG. 2 is a cross-sectional view of a flexible thermoelectric device according to the present invention
FIG. 3 is a schematic flowchart of a manufacturing method of a thermoelectric device according to the present invention.
FIG. 4 is a flowchart of a step of forming a thermoelectric material by a screen printing method according to an exemplary embodiment of the present invention.
FIG. 5 is a photograph illustrating a process of forming a thermoelectric material on a mesh type substrate according to an exemplary embodiment of the present invention.
FIG. 6 is a cross-sectional photograph taken along line A-A of FIG. 5.
FIG. 7 is a flowchart of a step of forming first and second electrodes and filling a filler according to an exemplary embodiment of the present invention.
FIG. 8 is a conceptual diagram of the step of forming first and second electrodes and filling a filler according to the exemplary embodiment of the present invention.
FIG. 9 is a graph illustrating a non-dimensional performance index (ZT) depending on a thickness ratio of a thick film of a thermoelectric material and a glass fabric.
FIG. 10 is a graph illustrating output power per unit area depending on a temperature difference (ΔT).
FIG. 11 is a graph illustrating output power per unit weight depending on the temperature difference (ΔT).
FIG. 12 is a graph acquired by measuring a change of internal resistance of a thermoelectric device depending on a curvature radius according to the present invention.
FIG. 13 is a graph illustrating measurement of a change of internal resistance of the device while repeatedly applying external stress having a curvature radius of 50 mm to the thermoelectric device according to the present invention.

### [Best Mode]

Hereinafter, exemplary embodiments of the present invention will be described in detail with reference to the accompanying drawings, but the present invention is not limited or restricted to the exemplary embodiments.

In describing the present invention, when it is determined that the detailed description of the publicly known art related to the present invention may obscure the gist of the present invention, the detailed description thereof will be omitted.

FIG. 2 is a cross-sectional view of a flexible thermoelectric device according to the present invention. Referring to FIG. 2, the flexible thermoelectric device 200 according to the present invention is configured to include a mesh type substrate 210, an N type thermoelectric material 230 and a P type thermoelectric material 240 formed on the mesh type substrate 210, and a first electrode 220 and a second electrode 250 which electrically connect the N type thermoelectric material 230 and the P type thermoelectric material 240 in series, and may be configured to further include a filler 270 that fills and supports the inside of the device.

The mesh type substrate 210 means a substrate with a net mesh having an appropriate size in such a manner that a paste type thermoelectric material can pass through the mesh type substrate 210 when the thermoelectric material is formed by a method such as screen printing, or the like so as to support a thermoelectric material not in an upper or lower part of the thermoelectric material but substantially in a middle part and the size of the net mesh is not particularly limited if the paste type thermoelectric material can pass through the mesh type substrate 210. The mesh type substrate 210 is preferably made of a material having thermal conductivity low as possible in order to maximize thermoelectric efficiency of the thermoelectric device 200 by minimizing thermal loss and as the mesh type substrate 210, a glass fabric substrate may be used. Since a glass fabric has a very light weight and high flexibility, the glass fabric is a material suitable to be applied to a lightweight flexible thermoelectric device and has an advantage that the glass fabric is suitable to manufacture the thermoelectric device using a high-temperature process due to high heat resistance. The mesh type substrate of the preset invention is not limited to the glass fabric substrate and as the mesh type substrate, an oxide or polymer fabric having thermal conductivity of 10 W/m· K or less may be used.

The thermoelectric materials 230 and 240 formed on the mesh type substrate 210 are composed of the N type thermoelectric material 230 and the P type thermoelectric material 240 and may be configured in a form in which substantially middle parts are penetrated and supported by the mesh type substrate 210 as illustrated in FIG. 2. The N type thermoelectric material 230 and the P type thermoelectric material 240 are preferably formed to be alternately positioned on the mesh type substrate 210 so that the N type thermoelectric material 230 and the P type thermoelectric material 240 are easily connected in series by the first and second electrodes 220 and 250. The thermoelectric materials 230 and 240 may be composed of one or more compounds of silicon (Si), aluminum (Al), calcium (Ca), sodium (Na), germanium (Ge), iron (Fe), lead (Pb), antimony (Sb), tellurium (Te), bismuth (Bi), cobalt (Co), cerium (Ce), tin (Sn), nickel (Ni), copper (Cu), sodium (Na), potassium (K), platinum (Pt), ruthenium (Ru), rhodium (Rh), gold (Au), tungsten (W), palladium (Pd), titanium (Ti), tantalum (Ta), molybdenum (Mo), hafnium (Hf), lanthanum (La), iridium (Ir), and silver (Ag), and for example, the N type thermoelectric material 230 may be a bismuth-tellurium (BiₓTe₁₋ₓ) compound and the P type thermoelectric material 240 may be an antimony-tellurium (SbₓTe₁₋ₓ) compound.

The first electrode 220 and the second electrode 250 are configured to connect the N type thermoelectric material 230 and the P type thermoelectric material 240 in series and as illustrated in FIG. 2, the first electrode 220 connects the N type thermoelectric material 230 and the P type thermoelectric material 240 on one surface of the device and the second electrode 250 connects the N type thermoelectric material 230 and the P type thermoelectric material 240 which are not connected by the first electrode 220 on the other surface of the device, and as a result, all N type thermoelectric materials 230 and P type thermoelectric materials 240 that are alternately formed on the mesh type substrate 210 may be configured to be connected in series by the first electrode 220 and the second electrode 250. The first and second electrodes 220 and 250 may be metal having high conductivity, such as nickel (Ni), aluminum (Al), copper (Cu), platinum (Pt), ruthenium (Ru), rhodium (Rh), gold (Au), tungsten (W), cobalt (Co), palladium (Pd), titanium (Ti), tantalum (Ta), iron (Fe), molybdenum (Mo), hafnium (Hf), lanthanum (La), iridium (Ir), and silver (Ag) and a conductive adhesive such as silver (Ag) paste, or the like may be further formed between the first and second electrodes 220 and 250 and the thermoelectric materials 230 and 240 in order to improve electric contact.

Further, since the thermoelectric device 200 according to the present invention is supported by only the mesh type substrate 210 without the upper and lower substrates 110 and 160 unlike the known thermoelectric device 100, it is preferable that a space between the N type thermoelectric material 230 and the P type thermoelectric material 240 is filled with the filler 270 so as to ensure mechanical stability as illustrated in FIG. 2. In this case, as the filler 270, a polymer material having low thermal conductivity and high flexibility may be used and for example, polydimethylsiloxane (PDMS) may be used.

### [Mode for Carrying Out the Invention]

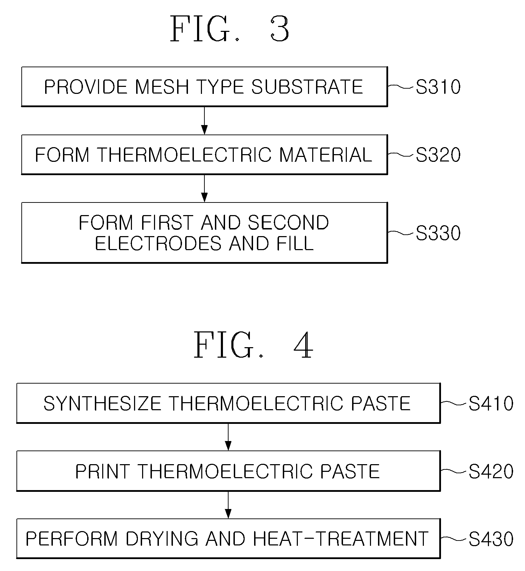

FIG. 3 is a schematic flowchart of a manufacturing method of a thermoelectric device according to the present invention. Referring to FIG. 3, the manufacturing method of the thermoelectric device according to the present invention may include a mesh type substrate providing step (S310), a thermoelectric material forming step (S320), and a step of forming first and second electrodes and filling a filler (S330).

In the mesh type substrate providing step (S310) as a step of providing a mesh type substrate 210 for forming thermoelectric materials 230 and 240, a glass fabric substrate is preferably used as the mesh type substrate.

In the thermoelectric material forming step (S320) as a step of sequentially forming an N type thermoelectric material 230 and a P type thermoelectric material 240 on the mesh type substrate 210, even any method may be used as long as the thermoelectric materials 230 and 240 may be formed while supported by the mesh type substrate 210, but the thermoelectric materials 230 and 240 are preferably formed by a screen printing method. The screen printing method is a method suitable for forming a thick film of several to hundreds of micrometers as a technique in which paste passes through a hole of a mask to be formed on a substrate in a predetermined pattern by putting on the substrate a screen mask having holes made in a predetermined pattern, and spraying the paste on the screen mask or pressing the paste with a pressing means.

FIG. 4 is a flowchart for, in more detail, describing a step 320 of forming a thermoelectric material by a screen printing method according to an exemplary embodiment of the present invention. Referring to FIG. 4, the thermoelectric material forming step (320) by the screen printing method according to the exemplary embodiment of the present invention may include a thermoelectric paste synthesizing step (S410), a thermoelectric paste printing step (S420), and a drying and heat-treatment step (S430).

In the thermoelectric paste synthesizing step (S410) as a step of synthesizing a paste material for screen printing, so as to form paste in which thermoelectric material powder is uniformly mixed with proper viscosity for uniform thermoelectric material layer deposition, the thermoelectric material powder, a solvent for controlling liquidity of the paste, a binder for controlling printing resolution, and glass powder for improving adhesion may be mixed. The thermoelectric material powder may be composed of one or more compounds of silicon (Si), aluminum (Al), calcium (Ca), sodium (Na), germanium (Ge), iron (Fe), lead (Pb), antimony (Sb), tellurium (Te), bismuth (Bi), cobalt (Co), cerium (Ce), tin (Sn), nickel (Ni), copper (Cu), sodium (Na), potassium (K), platinum (Pt), ruthenium (Ru), rhodium (Rh), gold (Au), tungsten (W), palladium (Pd), titanium (Ti), tantalum (Ta), molybdenum (Mo), hafnium (Hf), lanthanum (La), iridium (Ir), and silver (Ag), and for example, bismuth-tellurium (BiₓTe₁₋ₓ) compound powder may be used for synthesizing N type thermoelectric material paste and antimony-tellurium (SbₓTe₁₋ₓ) compound powder may be used for synthesizing P type thermoelectric material paste. Further, as the solvent, alcohol based and ketone based materials and as the binder, a resin based material may be used, and the glass powder may include glass frit composed of Bi₂O₃, ZnO, and B₂O₃ and in addition, glass fit including approximately 1 to 20 wt% of three or more oxides selected from a group consisting of Al₂O₃, SiO₂, CeO₂, Li₂O, Na₂O, and K₂O may be used.

The thermoelectric paste printing step (S420) is a step that deposits a thermoelectric material layer having a desired pattern on the mesh type by screen-printing the thermoelectric paste synthesized in the thermoelectric paste synthesizing step (S410) while putting the screen mask on the mesh type substrate. In this case, since the thermoelectric paste has some liquidity and viscosity, the thermoelectric material layer is not printed on the mesh type substrate but is printed in such a manner that the thermoelectric paste passes through even a lower part of the mesh type substrate, and as a result, the mesh type substrate supports a substantially middle part of the thermoelectric material.

Meanwhile, the printed thermoelectric material layer still includes the solvent and the binder, and a high-temperature annealing process is required to reveal a thermoelectric characteristic, and as a result, the drying and heat-treatment step (430) is performed. A drying and heat-treatment condition may be variously controlled and for example, the solvent is evaporated by putting the mesh type substrate printed with the thermoelectric material layer in an oven at approximately 100 to 200°C and drying the mesh type substrate for approximately 10 to 20 minutes, the binder is evaporated by heat-treating the mesh type substrate at a temperature (200°C or higher) higher than the solvent evaporation temperature for a predetermined time, and thereafter, last, annealing may be performed at a temperature higher than a temperature in the evaporation of the binder in order to improve the thermoelectric characteristic of the thermoelectric material layer. In this case, the annealing temperature may be 500°C or higher.

The thermoelectric material forming step (S320) needs to be performed for both the N type thermoelectric material 230 and the P type thermoelectric material 240, and in this case, the process of FIG. 4 may be repeated for each thermoelectric material. For example, the N type thermoelectric material 230 may be formed on the mesh type substrate 210 by performing the N type thermoelectric paste printing step (S420), and the drying and heat-treatment step (S430) after synthesizing the N type thermoelectric material paste and thereafter, the P type thermoelectric material 240 may be formed on the mesh type substrate 210 by performing the P type thermoelectric paste printing step (S420) and the drying and heat-treatment step (S430) for even the P type thermoelectric material paste. In this case, in the case where the drying and the heat-treatment may be performed at the same temperature, the drying and heat-treatment step (S430) may be simultaneously performed after N type thermoelectric paste printing and P type thermoelectric paste printing.

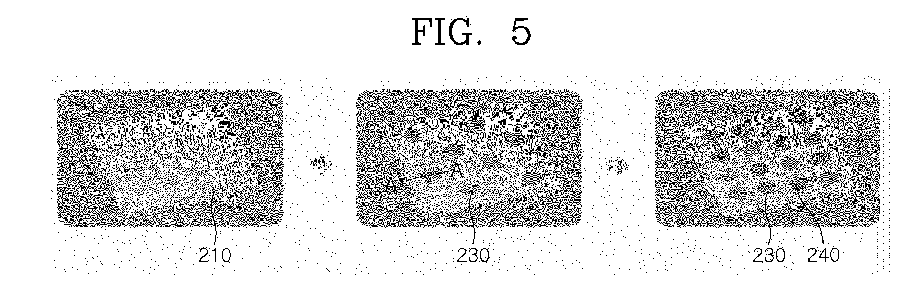

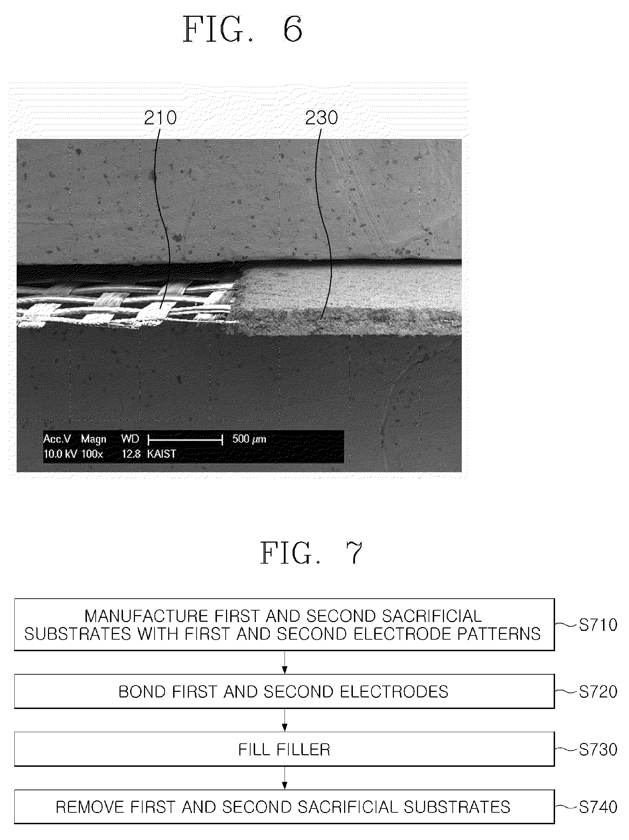

FIG. 5 is a photograph illustrating a process of forming a thermoelectric material on a mesh type substrate according to an exemplary embodiment of the present invention described above and FIG. 6 is a cross-sectional photograph taken along line A-A of FIG. 5. FIGS. 5 and 6 illustrate a case in which the N type thermoelectric material 230 and the P type thermoelectric material 240 are formed to be alternately positioned on the mesh type substrate 210 and it may be verified that the mesh type substrate 210 is manufactured to penetrate and support the substantially middle parts of the thermoelectric materials 230 and 240 through the processes of FIGS. 3 and 4.

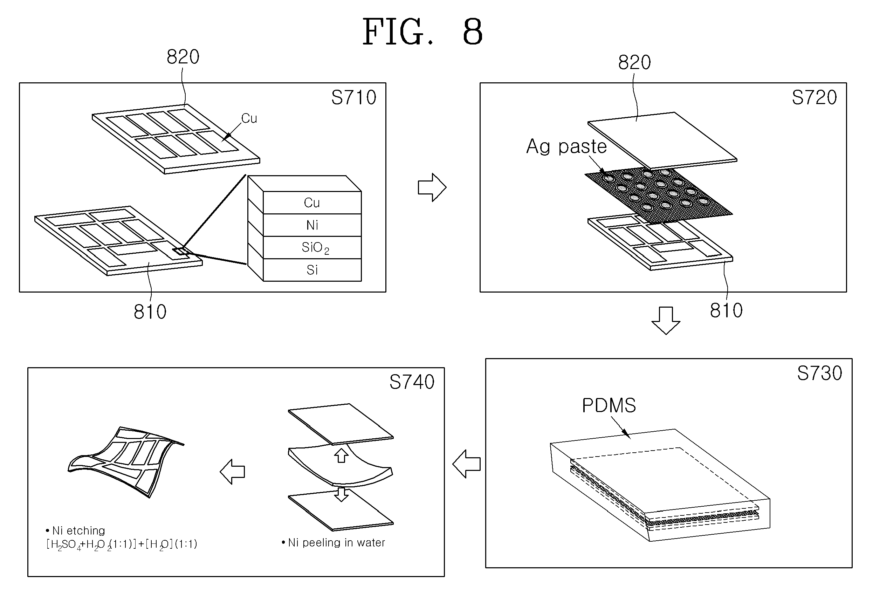

Referring back to FIG. 3, after step S320 of forming the thermoelectric material on the mesh type substrate 210 is completed, the step of forming first and second electrodes and filling a filler (S330) is performed. The step of forming first and second electrodes and filling a filler (S330) is a step of forming a first electrode 220 and a second electrode 250 that connect the N type and P type thermoelectric materials 230 and 240 which are alternately formed on the mesh type substrate in the thermoelectric material forming step (S320) in series and filling a filler 270 so as to ensure mechanical stability of the entire thermoelectric device 200 and in detail, may include a step (S710) of manufacturing first and second sacrificial substrates with first and second electrode patterns, a first and second electrode bonding step (S720), a filler filling step (S730), and a first and second sacrificial substrate removing step (S740) as illustrated in a flowchart of FIG. 7 and a conceptual diagram of FIG. 8.

Referring to FIGS. 7 and 8, first, the step (S710) of manufacturing the first and second sacrificial substrates with the first and second electrode patterns as a step of manufacturing sacrificial substrates for transferring the first and second electrode patterns to the mesh type substrate 210 with the thermoelectric material may be a step of depositing a nickel (Ni) thin film on a full surface of a silicon oxide film substrate and thereafter, depositing the first and second electrode patterns thereon. Herein, since the nickel thin film is a sacrifice film which needs to be etched and removed in a subsequent process, it is not preferable that the nickel thin film is excessively thick in order to shorten a process time and the nickel thin film may be formed with approximately hundreds of nanometers. Further, the first and second electrode patterns are not particularly limited, but may be formed by the screen printing method and may be formed by a copper film having high electric conductivity. Through such a process, as illustrated in FIG. 8, a first sacrificial substrate 810 in which a predetermined first electrode pattern is formed on the nickel thin film and a second sacrificial substrate 820 in which a predetermined second electrode pattern is formed on the nickel thin film are manufactured.

In the first and second electrode bonding step (S720) as a step of bonding the first and second sacrificial substrates 810 and 820 formed as above to upper and lower parts of the mesh type substrate 210 with the thermoelectric materials 230 and 240, the first and second electrodes are aligned and boned so as to connect the N type thermoelectric material 230 and the P type thermoelectric material 240 in series by the first electrode 220 and the second electrode 250. In this case, in order to improve adhesion of the thermoelectric materials 230 and 240 and the first and second electrodes 220 and 250, a conductive adhesive such as silver (Ag) paste, or the like is applied onto the thermoelectric materials or the first and second electrodes, which may be bonded.

When the first and second electrode bonding step (S720) is completed, a gap exists between the first sacrificial substrate 810 and the second sacrificial substrate 820, and the gap is approximately as large as the thickness of the thermoelectric materials 230 and 240 and the first and second electrodes 220 and 250 and in the filler filling step (S730), the filler 270 is filled in the gap. As the filler 270, PDMS may be used and PDMS fillers sufficiently permeate a space between the first sacrificial substrate 810 and the second sacrificial substrate 820 by immersing the first sacrificial substrate 810 and the second sacrificial substrate 820 in liquid PDMS for a predetermined time and thereafter, the first sacrificial substrate 810 and the second sacrificial substrate 820 are dried at a temperature of approximately 90°C for a predetermined time to form the filler 270.

Next, in the first and second sacrificial substrate removing step (S740), a characteristic in which adhesion between the nickel thin film and a silicon oxide film is not good is used. That is, when a sample in which the filler filling step (S730) is completed is immersed in water for a predetermined time, an interface between a silicon oxide film substrate and the nickel thin film of the first and second sacrificial substrates 810 and 820 is peeled and thereafter, when the nickel thin film which remains on both surfaces of the sample is removed by wet etching, a thermoelectric device structure of the present invention illustrated in FIG. 2 is acquired. In this case, although it is illustrated that the first and second sacrificial substrates 810 and 820 are fully surrounded by the PDMS through the filler filling step (S730) in FIG. 8, the interface between the silicon oxide film substrate and the nickel thin film needs to be exposed in order to remove the first and second sacrificial substrates 810 and 820, and as a result, it is necessary to appropriately remove at least the PDMS at the side.

Although the silicon oxide film substrate deposited with the nickel thin film has been used as the sacrificial substrate in the above exemplary embodiments, it is just an example and various types of sacrificial substrates including silicon (Si), silicon oxide (SiO₂), sapphire, alumina, mica, germanium (Ge), silicon carbon (SiC), gold (Au), silver (Ag), and polymer may be, of course, used in order to manufacture the thermoelectric device of the present invention. Further, the sacrificial film such as the nickel thin film may not be required due to an adhesion characteristic of the sacrificial substrates and the first and second electrodes.

Since the thermoelectric device 210 according to the present invention uses the mesh type substrate made of the glass fabric, and the like, the thermoelectric device 201 may have a flexible characteristic and a weight thereof may be considerably decreased. As a result of comparing the thermoelectric device 200 manufactured by the glass fabric mesh type substrate according to the present invention and the known thermoelectric device 100 illustrated in FIG. 1 in weight per unit device area (g/cm²), in the thermoelectric device 200 of the present invention,the weight per unit device area (g/cm²) is measured as 0.13 g/cm² and this value is a very small value which corresponds to 1/12 of 1.56 g/cm² of the known thermoelectric device 100 including a relatively thick substrate. This means that the thermoelectric device according to the present invention is very suitable for fields requiring a light and flexible thermoelectric device, such as a human body, a vehicle, an airplane, and a space shuttle.

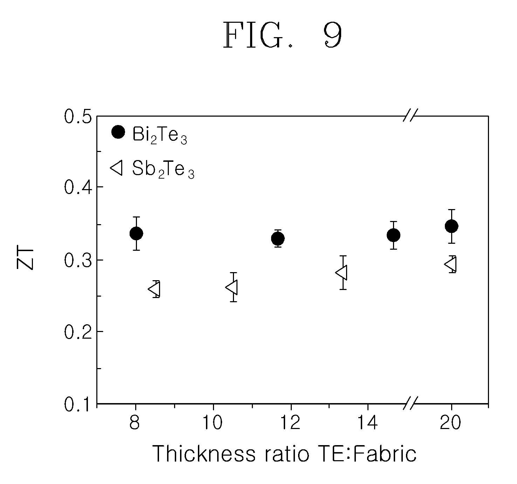

FIG. 9 is a graph illustrating a non-dimensional performance index (ZT) depending on a thickness ratio of a thick film (TE) of a thermoelectric material and a glass fabric after forming thick films of bismuth tellurium (BiₓTe₁₋ₓ) which is the N type thermoelectric material and antimony tellurium (SbₓTe₁₋ₓ) which is the P type thermoelectric material on the mesh type substrate made of the glass fabric according to the present invention. The non-dimensional performance index is a criterion to estimate thermoelectric efficiency of the thermoelectric material. From FIG. 9, when the thermoelectric material is formed on the glass fabric as described in the present invention, it may be verified that the non-dimensional performance index of the thermoelectric material is not influenced by the glass fabric. Since this means that when the mesh type glass fabric is used as the substrate, there is no loss of thermal energy by the substrate unlike alumina (Al₂O₃), silicon (Si), silicon oxide (SiO₂), and a polymer film, and the like which are substrates used in the related art, the thermoelectric device according to the present invention may achieve higher thermoelectric efficiency than the known thermoelectric device.

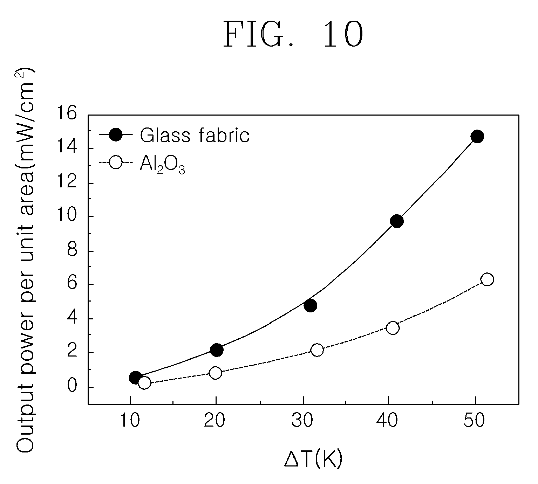

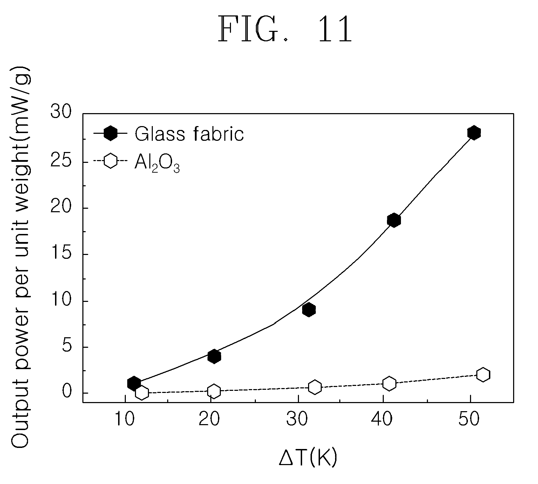

FIGS. 10 and 11 illustrate a result of comparing thermoelectric power generation characteristics of the thermoelectric device according to the present invention and the thermoelectric device in the related art. FIG. 10 is a graph illustrating output power per unit area depending on a temperature difference (AT) and FIG. 11 is a graph illustrating output power per unit weight depending on the temperature difference (AT) and it may be verified that the thermoelectric device according to the present invention shows much higher thermoelectric power generation efficiency. Herein, the temperature difference (ΔT) represents a difference in temperature between upper and lower parts of a thermoelectric power generation device (see FIGS. 1 and 2), and since the entirety of the temperature difference (AT) may be actually transformed to power by the thermoelectric materials 230 and 240 without thermal loss, the thermoelectric device 200 according to the present invention has much higher thermoelectric efficiency than the known thermoelectric device 100 in which a considerable part of the temperature difference (AT) is lost by the upper and lower substrates 110 and 160. Although such a degree of difference occurs depending on the temperature difference (ΔT), the thermoelectric device 200 according to the present invention shows approximately 150% per unit area and approximately 1400% per unit weight higher thermoelectric efficiency characteristic than the known thermoelectric device 100 according to the results of FIGS. 10 and 11.

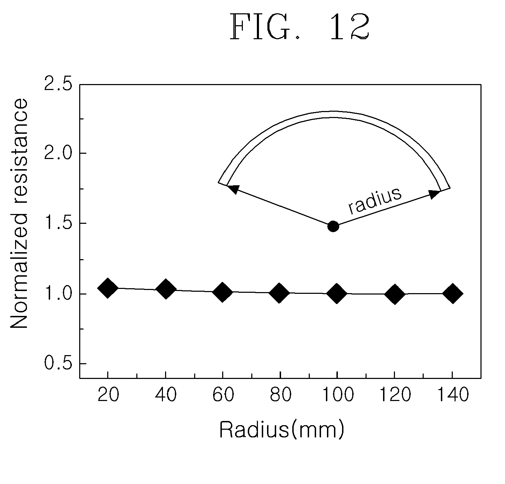

FIG. 12 is a graph acquired by measuring a change of internal resistance depending on a curvature radius of a device in order to measure a flexibility characteristic of the thermoelectric device 200 according to the present invention. Therefrom, when the thermoelectric device is implemented by using the mesh type substrate as in the present invention, it may be verified that the thermoelectric device shows a high flexibility characteristic in which the internal resistance of the device is not increased up to a curvature radius of 20 mm.

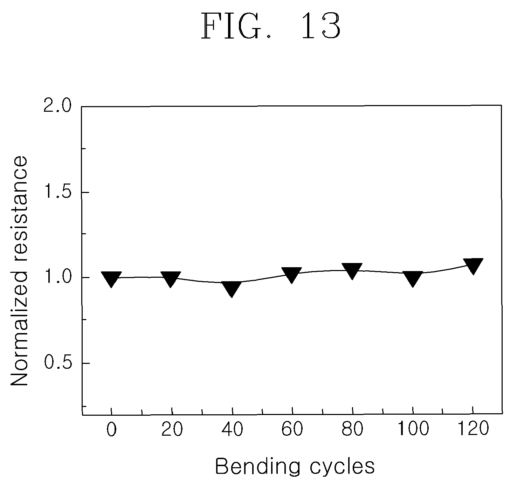

FIG. 13 is a graph illustrating measurement of a change of internal resistance of the device while repeatedly applying external stress having a curvature radius of 50 mm to the thermoelectric device 200 according to the present invention. Therefrom, when the thermoelectric device is implemented by using the mesh type substrate as in the present invention, it may be verified that the thermoelectric device shows a high flexibility characteristic in which the internal resistance of the device is not increased in spite of repeatedly applying external stress approximately 120 times with the curvature radius of 50 mm.

Although the present invention has been described with reference to the limited exemplary embodiments and drawings as above, this is exemplary and it will be apparent to those skilled in the art that various modifications can be made within the scope of the technical spirit of the present invention. Accordingly, the protection scope should be determined according to the appended claims and equivalents thereto.

### [Industrial Applicability]

According to the present invention, since a thermoelectric device can be provided, which has a light weight, high thermoelectric efficiency, and a flexible characteristic, the thermoelectric device can be usefully used in fields requiring the lightweight thermoelectric device, such as a human body, a vehicle, an airplane, and a space shuttle or fields requiring the thermoelectric device having the flexible characteristic, such as a wearable computer, and the like.

## Claims

1. A flexible thermoelectric device, comprising:
a mesh type substrate;
an N type thermoelectric material and a P type thermoelectric material formed on the mesh type substrate; and
a first electrode and a second electrode which electrically connect the N type thermoelectric material and the P type thermoelectric material in series.

2. The flexible thermoelectric device of claim 1, further comprising:
a filler which is filled in the thermoelectric device to support the thermoelectric device.

3. The flexible thermoelectric device of claim 1 or 2,
wherein the mesh type substrate penetrates and supports middle parts of the N type thermoelectric material and the P type thermoelectric material.

4. The flexible thermoelectric device of claim 3,
wherein the N type thermoelectric material and the P type thermoelectric material are alternately positioned.

5. The flexible thermoelectric device of claim 3, wherein the first electrode connects the N type thermoelectric material and the P type thermoelectric material on one surface of the thermoelectric device, and
the second electrode connects an N type thermoelectric material and a P type thermoelectric material which are not connected by the first electrode on the other surface of the thermoelectric device,
to connect all N type thermoelectric materials and P type thermoelectric materials formed on the mesh type substrate in series the first electrode and the second electrode.

6. The flexible thermoelectric device of claim 1 or 2, wherein the mesh type substrate is a glass fabric substrate.

7. The flexible thermoelectric device of claim 1 or 2, wherein the mesh type substrate has thermal conductivity of 10 W/ m·K or lower.

8. The flexible thermoelectric device of claim 1 or 2, wherein the N type thermoelectric material is a bismuth-tellurium (BiₓTe₁₋ₓ) compound, and
the P type thermoelectric material is an antimony-tellurium (SbₓTe₁₋ₓ) compound.

9. The flexible thermoelectric device of claim 1 or 2, further comprising a conductive adhesive between the N type thermoelectric material and the P type thermoelectric material and the first electrode and the second electrode.

10. A manufacturing method of a flexible thermoelectric device using a mesh type substrate, the method comprising:
(a) providing the mesh type substrate;
(b) forming an N type thermoelectric material and a P type thermoelectric material on the mesh type substrate; and
(c) forming a first electrode and a second electrode which electrically connect the N type thermoelectric material and the P type thermoelectric material in series, and filling a space between the N type thermoelectric material and the P type thermoelectric material with a filler.

11. The manufacturing method of a flexible thermoelectric device of claim 10, wherein step (b) is performed by a screen printing method.

12. The manufacturing method of a flexible thermoelectric device of claim 11, wherein step (b) includes:
(b-1) thermoelectric paste synthesizing;
(b-2) thermoelectric paste printing; and
(b-3) drying and heat-treatment.

13. The manufacturing method of a flexible thermoelectric device of claim 12, wherein in step (b-1), thermoelectric material powder, a solvent for controlling liquidity of paste, a binder for controlling printing resolution, and glass powder for improving adhesion are mixed.

14. The manufacturing method of a flexible thermoelectric device of claim 12, wherein at least a part of the thermoelectric paste passes through the mesh type substrate and is printed in such a manner that the mesh type substrate supports a middle part of the printed thermoelectric paste by step (b-2).

15. The manufacturing method of a flexible thermoelectric device of claim 13, wherein step (b-3) includes:
first heat-treatment for evaporating the solvent;
second heat-treatment for evaporating the binder; and
third heat-treatment for increasing a thermoelectric characteristic of the thermoelectric material, and
the first, second, third heat-treatments are sequentially performed at a higher temperature.

16. The manufacturing method of a flexible thermoelectric device of claim 10, wherein step (c) includes:
(c-1) manufacturing first and second sacrificial substrates with first and second electrode patterns;
(c-2) first and second electrode bonding in which the first and second electrode patterns are bonded to the N type thermoelectric material and the P type thermoelectric material formed on the mesh type substrate to connect the N type thermoelectric material and the P type thermoelectric material in series;
(c-3) filler filling of filling a space between the first sacrificial substrate and the second sacrificial substrate with a filler; and
(c-4) removing the first and second sacrificial substrates.

17. The manufacturing method of a flexible thermoelectric device of claim 16, wherein step (c-1) includes depositing a nickel (Ni) thin film on a full surface of a silicon oxide film substrate and thereafter, depositing the first and second electrode patterns thereon.

18. The manufacturing method of a flexible thermoelectric device of claim 16, wherein step (c-2) includes applying a conductive adhesive to at least one of the thermoelectric materials and the first and second electrodes.

19. The manufacturing method of a flexible thermoelectric device of claim 17, wherein step (c-4) includes removing the nickel thin film which remains on both surfaces of the device after peeling an interface between the silicon substrate and the nickel thin film of the first and second sacrificial substrates.
